# EUROPÄISCHE PATENTSCHRIFT

(11) **EP 1 040 738 B1**
(45) Veröffentlichungstag und Bekanntmachung des Hinweises auf die Patenterteilung: **29.08.2001**
(21) Anmeldenummer: 98966518.7
(22) Anmeldetag: 09.12.1998
(51) Int. Cl.: H05K 7/20

(54) **ANORDNUNG ZUM KÜHLEN VON ELEKTRISCHEN BAUGRUPPEN**
DEVICE FOR COOLING ELECTRICAL SUBASSEMBLIES
DISPOSITIF POUR REFROIDIR DES COMPOSANTS ELECTRIQUES

(30) Priorität: 16.12.1997 DE 19755944
(43) Veröffentlichungstag der Anmeldung: 04.10.2000
(73) Patentinhaber: SIEMENS AKTIENGESELLSCHAFT, 80333 München (DE); W.L. GORE & ASSOCIATES GmbH, 85640 Putzbrunn (DE)
(72) Erfinder: REECK, Guido, D-80469 München (DE); HOEFER, Bruno, D-82140 Olching (DE); GAHSE,Alfred, D-82024 Taufkirchen (DE)
(86) Internationale Anmeldenummer: DE9803621
(87) Internationale Veröffentlichungsnummer: WO9931947

(56) Entgegenhaltungen:
- DE-A- 19 626 778
- US-A- 5 477 417
- US-A- 5 646 823
- PATENT ABSTRACTS OF JAPAN vol. 018, no. 248 (C-1198), 12. Mai 1994 & JP 06 031130 A (NEC CORP), 8. Februar 1994
- J. R. HAMMER AND R. L. SYLER: "Ventilation system for data processing systems" IBM TECHNICAL DISCLOSURE BULLETIN , Bd. 17, Nr. 9, Februar 1975, Seiten 2529-2530, XP002102848 New York,US

## Beschreibung

Die Erfindung betrifft eine Anordnung zum Kühlen von in einem Gehäuse angeordneten elektrischen Baugruppen, insbesondere für eine Verwendung in Basisstationen eines Mobilfunksystems oder Access-Network-Systems, vgl. z.B. US-A-5646823.

Technische Geräte erzeugen während des Betriebs Abwärme, die zu einer Erwärmung des Gerätes führt. Da ein technisches Gerät seine Funktionalität nur in einem eingeschränkten Temperaturbereich gewährleisten kann, sind üblicherweise Anordnungen zum Kühlen dieses Gerätes vorgesehen.

In elektrisch betriebenen Geräten führt die Verlustleistung stromdurchflossener Bauelemente und Baugruppen zu einer Erwärmung. Sind solche technischen Geräte nicht in geschützten, temperierten Räumen installiert, ist beim Betrieb nicht nur der zulässige Temperaturbereich der elektrischen Baugruppen, sondern zugleich auch der mögliche Temperaturbereich der Umgebung des technischen Gerätes zu beachten. Beide Temperaturbereiche sind bei der Dimensionierung der Anordnung zum Kühlen zu berücksichtigen. Standardbauelemente für ein technisches Gerät haben beispielsweise einen zulässigen Betriebstemperaturbereich von 0 bis 70°C. Derartige Bauelemente werden z.B. in Basisstationen eines Mobilfunksystems oder Access-Network-Systems, jedoch auch in anderen technischen Geräten wie beispielsweise Verkehrsleiteinrichtungen oder Versorgungseinrichtungen eingesetzt. Weiterhin muß für die elektrischen Bauelemente und Baugruppen ein ausreichender Schutz vor Schmutzpartikeln und eindringender Feuchtigkeit vor allem bei einem Einsatz außerhalb geschlossener Räume sichergestellt sein, wobei Schutzbestimmungen nach den spezifizierten IP-Klassen eingehalten werden müssen.

In Basisstationen nach dem Stand der Technik, wie er beispielsweise aus der älteren deutschen Patentanmeldung 19626778.1 bekannt ist, wird das Problem der Kühlung der elektrischen Bauelemente und Baugruppen bei einem gleichzeitigen Schutz vor Schmutz und Feuchtigkeit ab einer bestimmten IP-Klasse durch den Einsatz von zwei durch einen Luft/Luft-Wärmetauscher getrennten Kühlkreisläufen gelöst. Dabei ist die Atmosphäre und der durch einen oder mehrere Lüfter erzeugte Luftstrom im Inneren der Basisstation vollständig von der äußeren Umgebungsatmosphäre getrennt. Der aufwendige zwei Kühlkreisläufe beinhaltende Aufbau der Basisstation wirkt sich allerdings nachteilig auf die Kosten, das Volumen und das Gewicht der Basisstation aus. Ebenso besitzt dieser Aufbau den Nachteil, daß die Kühlanordnung erst ab einem bestimmten Temperaturgefälle zwischen der Atmosphäre im Inneren der Basisstation und der Umgebungsatmosphäre arbeitet, wodurch die Temperatur im Inneren immer über der Temperatur der Umgebungsatmosphäre liegt. Hierbei kann es unter Umständen dazu kommen, daß die obere Grenztemperatur (bspw. 70°C) einzelner Bauelemente oder Baugruppen überschritten wird, wenn die Temperatur der Umgebungsatmosphäre die korrespondierenden Grenztemperaturen überschreitet. Allgemein gilt: Umgebungstemperatur + Wärmetauscher-Temperaturdifferenz ΔT + innere Erwärmung !< Bauteilegrenztemperatur (z.B. 70°C). Um die für die Kühlung benötigte Temperaturdifferenz ΔT zu verringern, ist ein hoher technischer Aufwand bei einer gleichzeitigen Vergrößerung des Volumens der Basisstation oder alternativ der Einsatz sogenannter aktiver Kühlgeräte wie Kompressoren, Peltiermodule etc. notwendig.

Der Erfindung liegt daher die Aufgabe zugrunde, eine Anordnung zum Kühlen zu schaffen, die die beschriebenen Nachteile der Anordnungen gemäß dem Stand der Technik umgeht.

Diese Aufgabe wird durch die Anordnung zum Kühlen von in einem Gehäuse angeordneten elektrischen Baugruppen nach Patentanspruch 1 gelöst. Vorteilhafte Weiterbildungen der Erfindung sind den Unteransprüchen zu entnehmen.

Dabei weist die erfindungsgemäße Anordnung zumindest einen in jeweils einem Lufteinlaß des Gehäuses angeordneten wasserabweisenden Membranfilter für eine Oberflächenfilterung von Schmutzpartikeln aus einströmender Kühlluft zum Kühlen von elektrischen Baugruppen sowie zumindest eine Kühleinrichtung zum Aufbauen einer Luftströmung in dem Gehäuse und zum Herausführen der gefilterten, aufgrund eines Durchströmens der Baugruppen erwärmten, Kühlluft durch zumindest einen Luftauslaß aus dem Gehäuse auf.

Die Ausgestaltung der erfindungsgemäßen Anordnung besitzt den Vorteil, daß gegenüber Kühlanordnungen nach dem Stand der Technik durch das Zusammenwirken der einzelnen Merkmale ein einfacher Aufbau der Anordnung zum Kühlen ermöglicht wird. Dabei wird trotz der Tatsache, daß nur ein Kühlluftstrom anstatt der zwei Kühlkreisläufe nach dem Stand der Technik existiert, eine optimale Kühlung der elektrischen Baugruppen bei gefordertem gleichzeitigen Schutz der Baugruppen vor Schmutzpartikeln und eindringender Feuchtigkeit erreicht und eine höhere Temperatur der Umgebungsatmosphäre aufgrund einer nicht existierenden Temperaturdifferenz ΔT zugelassen. Durch die von der Kühleinrichtung aufgebaute Luftströmung wird die in den Baugruppen erwärmte Kühlluft aus dem Gehäuse herausgeführt und neue Kühlluft strömt aus der Umgebungsatmosphäre durch das Membranfilter in das Gehäuse. Dabei wird die einströmende Kühlluft in dem Membranfilter von Schmutzpartikeln befreit, wodurch vorteilhaft auch strenge Schutzbestimmungen erfüllt werden können. Das Membranfilter ist als ein wasserabweisendes Oberflächenfilter ausgeführt, welches vorteilhaft ein Eindringen von Schmutzpartikeln in das Filter verhindert und somit ein einfaches Reinigen ermöglicht.

In einer ersten Ausgestaltung weist die erfindungsgemäße Anordnung jeweils unterhalb und/oder oberhalb der elektrischen Baugruppen Luftleiteinrichtungen zum Leiten der einströmenden, gefilterten Kühlluft durch jeweils eine Baugruppe und/oder zur Abschirmung der elektrischen Baugruppen auf. Durch diese Luftleiteinrichtungen wird vorteilhaft eine homogene Verteilung der einströmenden Kühlluft über die Grundfläche der jeweiligen elektrischen Baugruppen und somit eine gleichmäßige Kühlung der elektrischen Baugruppen erreicht.

Gemäß weiteren Ausgestaltungen der Erfindung besteht die Kühleinrichtung aus einem durch einen Motor angetriebenen Lüfterrad, wobei weitergehend die Motordrehzahl und somit der Durchsatz der Kühlluft in dem Gehäuse durch eine Steuereinrichtung in Abhängigkeit von der Temperatur im Gehäuse und/oder von der Temperatur der Umgebungsatmosphäre und somit der Temperatur der einströmenden Kühlluft gesteuert wird. Hierdurch kann beispielsweise eine konstante Arbeitstemperatur der elektrischen Baugruppen und eine konstante Temperatur im Inneren des Gehäuses sichergestellt und somit vorteilhaft die Lebensdauer der elektrischen Baugruppen verlängert werden. Weiterhin kann die Drehzahl der Kühleinrichtung jeweils in der Weise geregelt werden, daß die zulässigen Grenztemperaturen der elektrischen Baugruppen gerade nicht überschritten werden und die Geräuschemission der Anordnung durch die möglichst niedrige Drehzahl der Kühleinrichtung minimiert wird.

Weiterhin kann durch eine entsprechend ausgestaltete Kühleinrichtung eine Umkehr der Richtung der Luftströmung in dem Gehäuse vorgenommen werden, so daß Kühlluft durch den Luftauslaß in das Gehäuse einströmt und durch den Membranfilter herausgeführt wird, wodurch vorteilhaft an der Oberfläche des Membranfilters abgelagerte Schmutzpartikel entfernt werden.

Der Lufteinlaß ist nach einer weiteren Ausgestaltung im seitlichen und/oder im unteren Bereich des Gehäuses derart angeordnet, daß die einströmende Kühlluft an den Unterseiten der Baugruppen angreift und somit vorteilhaft ein Durchströmen der Baugruppen in der Weise ermöglicht wird, daß die beim Durchströmen der elektrischen Baugruppen erwärmte Kühlluft von der Kühleinrichtung angesaugt und durch zumindest einen im oberen und/oder seitlichen Bereich des Gehäuses angeordneten Luftauslaß herausgeführt wird.

Die erfindungsgemäße Anordnung eignet sich insbesondere für einen Einsatz in Basisstationen oder ähnlichen Outdoor-Anlagen eines Mobilfunksystems oder Access-Network-Systems, sowie in vergleichbaren technischen Geräten wie Verkehrsleiteinrichtungen, Richtfunkeinrichtungen u.ä., die innerhalb eines großen Temperaturbereiches einsatzbereit sein müssen.

Ausführungsbeispiele der Erfindung werden anhand der beiliegenden Zeichnungen näher erläutert.

Dabei zeigen
- FIG 1: eine Basisstation eines Mobilfunksystems mit einer Anordnung zum Kühlen nach dem Stand der Technik in einer Vorderansicht,
- FIG 2: eine beispielhafte Basisstation mit der erfindungsgemäßen Anordnung zum Kühlen von elektrischen Baugruppen in einer Vorderansicht,
- FIG 3: eine beispielhafte Basisstation mit einer erfindungsgemäßen Anordnung zum Kühlen von elektrischen Baugruppen in einer Seitenansicht, und
- FIG 4: eine beispielhafte Basisstation mit einer erfindungsgemäßen Anordnung zum Kühlen von elektrischen Baugruppen mit zusätzlichen Merkmalen in einer Seitenansicht,
- FIG 5: eine beispielhafte Basisstation mit einer erfindungsgemäßen Anordnung zum Kühlen von elektrischen Baugruppen mit mehreren Kühleinrichtungen,
- FIG 6: eine beispielhafte Basisstation mit einer erfindungsgemäßen Anordnung zum Kühlen von elektrischen Baugruppen mit mehreren Kühleinrichtungen in einer geänderten Anordnung.

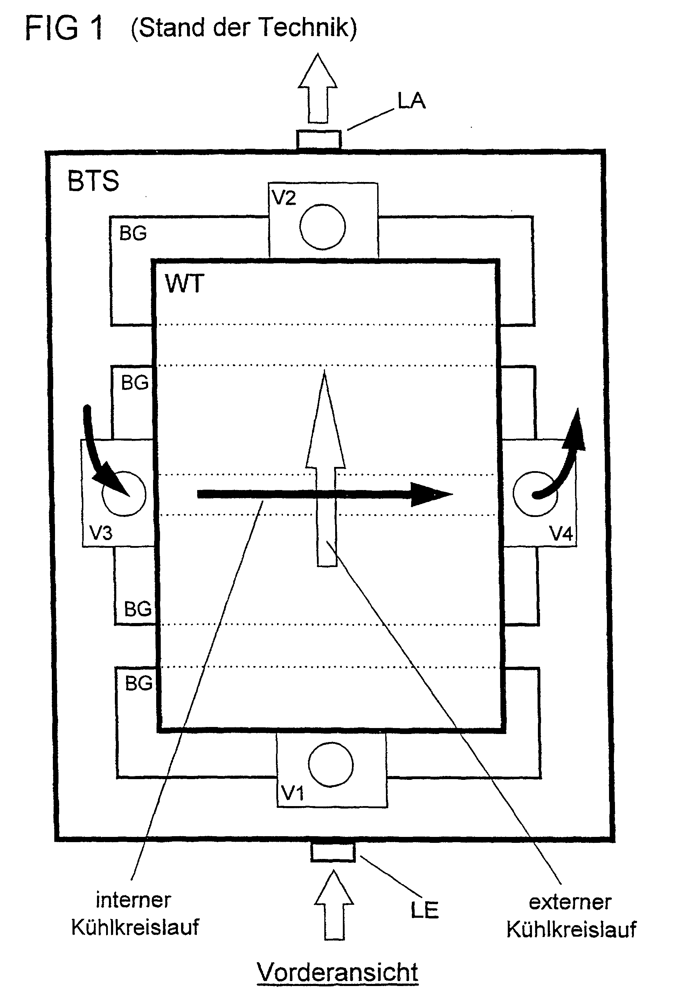

Die Basisstation BTS beispielsweise eines Mobilfunksystems nach dem Stand der Technik gemäß FIG 1 enthält mehrere elektrische Baugruppen BG. Während des Betriebes der Basisstation BTS führt die Verlustleistung der einzelnen elektrischen Baugruppen BG zu einer Erwärmung, wodurch die Notwendigkeit einer Kühlung entsteht. Die Kühlung erfolgt durch in mehreren Kühlkreisläufen eingebundene Kühleinrichtungen V.

Es handelt sich bei diesen Kühlkreisläufen um zwei durch schwarze und weiße Pfeile gekennzeichnete und voneinander jeweils getrennte Kühlkreisläufe, einen externen und einen internen Kühlkreislauf, wobei die beiden Kühlkreisläufe durch einen Luft/Luft-Wärmetauscher WT voneinander getrennt sind.

Der externe Kühlkreislauf wird durch zwei Kühleinrichtungen V1 und V2 bewirkt. Durch einen Lufteinlaß LE auf einer Seite der Basisstation BTS wird von der ersten Kühleinrichtung V1 Luft mit der Temperatur der Umgebungsatmosphäre in die Basisstation BTS eingesaugt. In dem Wärmetauscher WT erwärmt sich die Luft und wird anschließend durch die zweite Kühleinrichtung V2 aus einem Luftauslaß LA auf der entgegengesetzten Seite der Basisstation BTS herausgedrückt. Dieser externe Kühlkreislauf verläuft nach FIG 1 beispielsweise in vertikaler Richtung.

Der zweite, im Inneren der Basisstation BTS befindlicher Kühlkreislauf verläuft durch den Wärmetauscher WT in horizontaler Richtung. Hier bewirken zwei weitere Kühleinrichtungen V3 und V4 den internen Kühlkreislauf. Durch die dritte Kühleinrichtung V3 wird Warmluft aus den Baugruppen BG in den Wärmetauscher WT angesaugt. Die warme Luft passiert die Platten bzw. Rippen des Wärmetauschers WT und gibt dabei Wärmeenergie an diese Kühlplatten bzw. -rippen und letztlich an den externen Kühlkreislauf ab. Die vierte Kühleinrichtung V4 drückt die abgekühlte Luft wiederum in die Baugruppen BG.

Dieser zweigeteilte Kühlkreislauf führt die entstehende Wärme im Inneren der Basisstation BTS an die Umgebungsatmosphäre der Basisstation BTS ab. Als Kühleinrichtungen V1 bis V4 werden in der Regel bekannte Ventilatoren eingesetzt, da ein Austausch der Luft aufgrund natürlicher Konvektion durch die starke Erwärmung der Baugruppen nicht ausreichend ist.

Der Aufbau der Basisstation BTS mit einem zweigeteilten Kühlkreislauf führt zu den bereits in der Beschreibungseinleitung erwähnten Nachteilen eines hohen technischen Aufwandes, hoher Kosten, hohen Gewichts, großen Volumens und einer nachteilig auftretenden notwendigen Temperaturdifferenz ΔT zwischen dem inneren und äußeren Kühlkreislauf, wobei der inneren Kreislauf stets um ΔT wärmer als der kühlende äußere Kreislauf ist.

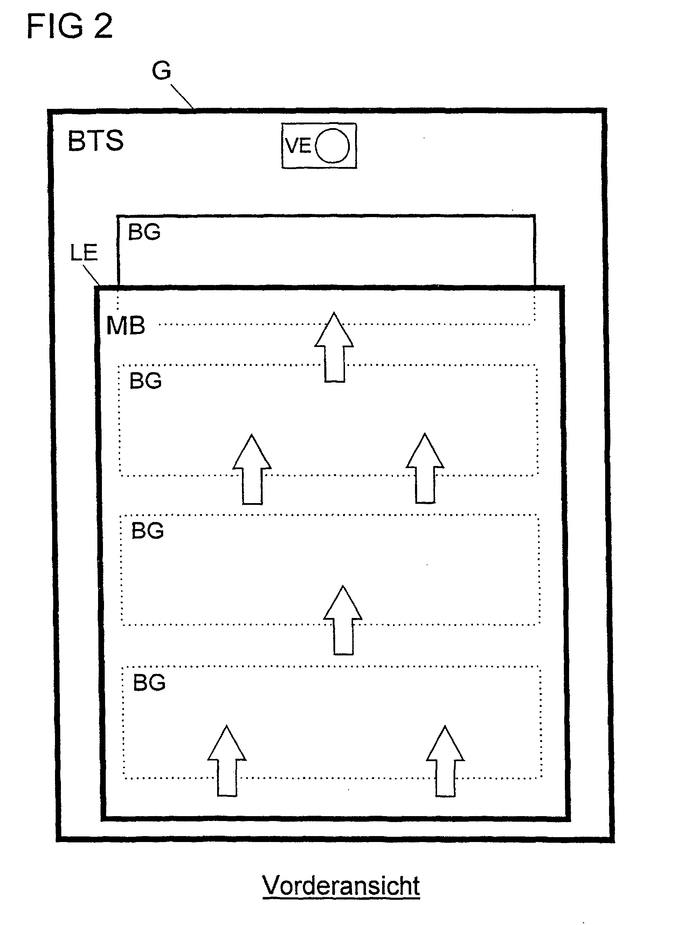

In der FIG 2 wird eine Basisstation BTS mit wie in der Basisstation BTS nach dem Stand der Technik angeordneten elektrischen Baugruppen BG ebenfalls in einer Vorderansicht dargestellt. In einem an der Stirnseite des Gehäuses G der Basisstation BTS vorgesehenen Lufteinlaß LE ist ein Membranfilter MB angeordnet, wobei der Lufteinlaß LE eine derartige Größe besitzt, daß durch den Membranfilter MB einströmende Kühlluft aus der Umgebungsatmosphäre der Basisstation BTS die elektrischen Baugruppen BG jeweils von unten und gegebenenfalls von vorne durchströmen kann und somit ein Abkühlen der Baugruppen bewirkt. Die aktive Fläche des Membranfilters MB, welche beispielsweise durch eine Faltenbildung größer als der Lufteinlaß LE sein kann, ist so dimensioniert, daß der Druckabfall der einströmenden Kühlluft durch die Kühleinrichtung VE kompensiert werden kann bzw. trotz eines teilweisen Zusetzens des Membranfilters MB durch Schmutzpartikel noch genügend Kühlluft einströmen kann. Eine im oberen Bereich des Gehäuses G angeordnete Kühlanordnung VE saugt die bei der Durch- und Umströmung der elektrischen Baugruppen BG erwärmte Kühlluft an und führt sie durch einen Luftauslaß LA (nicht dargestellt) an die Umgebungsatmosphäre ab.

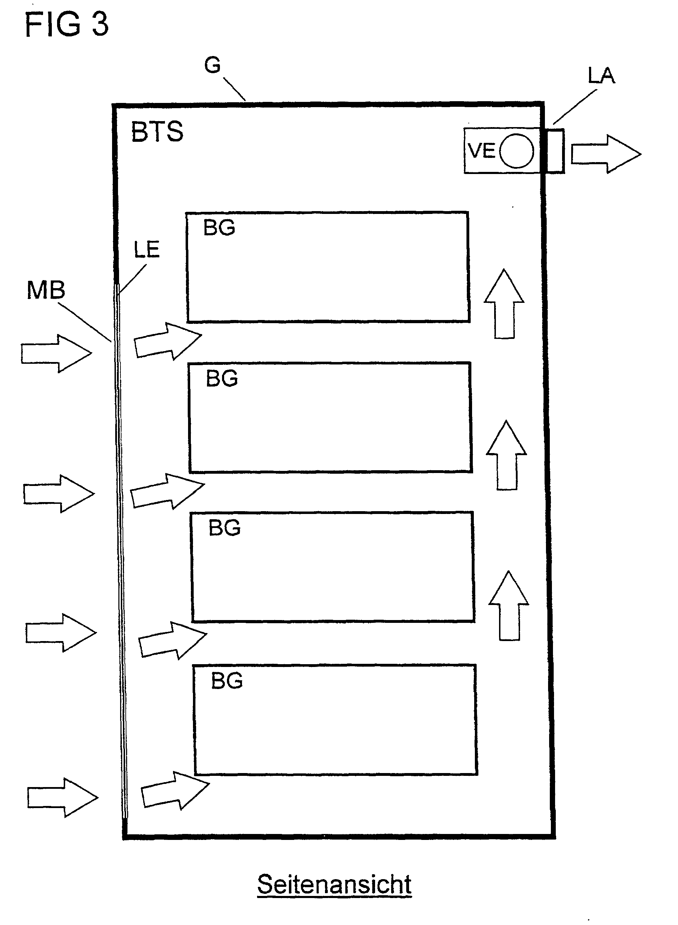

Die FIG 3 stellt die in der FIG 2 beschriebene Basisstation BTS in einer Seitenansicht dar, um den beispielhaften inneren Aufbau näher darzustellen. Auf der linken Seite des Gehäuses G der Basisstation BTS ist in dem Lufteinlaß LE der Membranfilter MB angeordnet. Der Membranfilter MB ist beispielhaft als ein Oberflächenfilter ausgeführt, der die besonders vorteilhafte Eigenschaft besitzt, Schmutzpartikel und Wasser bzw. Feuchtigkeit der Umgebungsatmosphäre bereits an der Oberfläche der Membrane abzuscheiden, wodurch beispielsweise empfindliche elektronische Bausteine oder Schaltungen in den Baugruppen BG gegen derartige Umwelteinflüsse geschützt werden. Durch spezielle Auslegungen des Membranfilters MB können Schutzbestimmungen nach den IP-Richtlinien bis beispielsweise IP55 erfüllt werden. Weiterhin besitzt die Kühlung der Baugruppen durch die Durchströmung des Gehäuses G mit Kühlluft den direkten Vorteil einer gegen Null tendierenden notwendigen Temperaturdifferenz ΔT zwischen der Temperatur der Umgebungsatmosphäre und somit der Temperatur der einströmenden Kühlluft und der Temperatur im Inneren des Gehäuses, wodurch der Betrieb der elektrischen Baugruppen BG auch bei einer Temperatur der Umgebungsatmosphäre von beispielsweise +70°C, die der Grenztemperatur der Bauelemente entspricht, vermindert um den Grad der inneren Erwärmung (s.o.), gesichert ist.

Von der beispielshaft in dem hinteren, oberen Bereich des Gehäuses G angeordnete Kühleinrichtung VE angesogene Kühlluft strömt aus der Umgebungsatmosphäre durch den Membranfilter MB in das Gehäuse G der Basisstation BTS ein. Durch die gegenüberliegende Anordnung des Lufteinlasses LE und des Luftauslasses LA durchströmt die gefilterte Kühlluft die in dem Gehäuses G angeordneten elektrischen Baugruppen BG. Durch die Anordnung mit einem bestimmten Abstand der Baugruppen BG untereinander erfolgt die Durchströmung jeweils zumindest von der Unterseite der Baugruppen BG und kann zusätzlich von der Vorderseite oder von der Seite in Form einer Umströmung erfolgen. Nach einer bekannten Bauart bestehen die Baugruppen BG beispielsweise aus einem Einschubgehäuse mit darin befindlichen elektronischen Bauelementen und Hochleistungsschaltkreisen. Die Einschubgehäuse sind mit Lüftungsschlitzen ausgestattet, durch die Kühlluft zu den Bauelementen und Schaltkreisen gelangen kann.

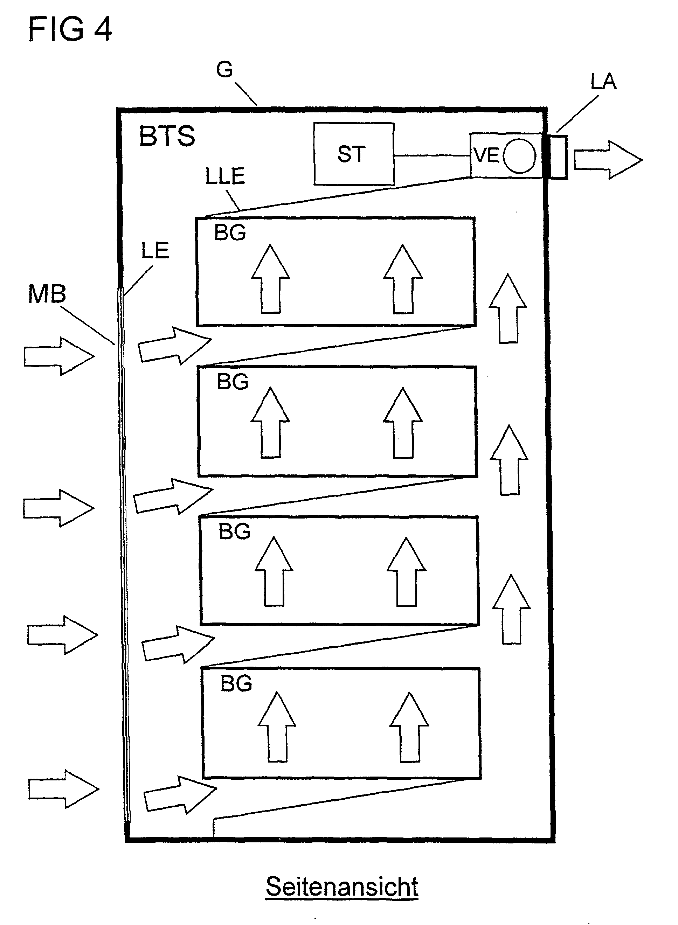

Die Basisstation BTS in der FIG 4 weist zusätzlich zu der Basisstation BTS in der FIG 3 Luftleiteinrichtungen LLE jeweils in den Räumen zwischen den einzelnen Baugruppen BG sowie unter der untersten und über der obersten Baugruppe BG auf. Diese Luftleiteinrichtung LLE dienen dem Zweck, die durch den Membranfilter MB einströmende Kühlluft gleichmäßig über die Grundfläche der jeweiligen Baugruppe BG zu verteilen, so daß es zu einer homogenen Durchströmung der gesamten Baugruppe BG kommt. Weiterhin wird durch die schrägstehende Anordnung die einströmende Kühlluft direkter zu den Baugruppen BG sowie die in den Baugruppen BG erwärmte Kühlluft direkter zu der Kühleinrichtung VE geführt. Vorteilhaft wird durch diese Anordnung verhindert, daß bereits erwärmte Kühlluft eine oder mehrere weitere Baugruppen BG durchströmt und es zu einer Temperaturüberhöhung einiger Baugruppen BG kommt. Weiterhin können die Luftleiteinrichtungen LLE zum gegenseitigen Abschirmen der Baugruppen BG in Hinblick auf die Erfüllung von Schutzbestimmungen über elektromagnetische Strahlungen verwendet werden.

Zur Regelung der Temperatur im Inneren des Gehäuses G wird die Drehzahl des Elektromotors der Kühleinrichtung VE durch eine Steuereinrichtung ST angesteuert. Zur Erfassung von Parametern für diese Steuerung können beispielsweise in dem Bereich des Lufteinlasses LE und an verschiedenen Stellen innerhalb des Gehäuses G Temperaturfühler vorgesehen werden, die permanent die Temperaturen der einströmenden Kühlluft und der Atmosphäre im Inneren des Gehäuses G ermitteln. Bei dieser Regelung wird durch die Drehzahl des Elektromotors der Kühleinrichtung VE der Durchsatz der Kühlluft in dem Gehäuse G verändert, um beispielsweise eine konstante Temperatur im Inneren des Gehäuses G unabhängig von der Temperatur der Umgebungsatmosphäre zu erhalten. Eine konstante Betriebstemperatur der Baugruppen BG wirkt sich beispielsweise positif auf die Betriebsdauer der elektronischen Bauteile und der Hochleistungsschaltkreise aus. Zusätzlich ermöglicht eine stets niedrig gehaltene Drehzahl der Kühleinrichtung VE, unter der Bedingung, daß die Grenztemperatur von +70°C nicht überschritten wird, eine Minimierung der Geräuschemission der Basisstation BTS. Weiterhin kann durch die Regelung bei einem Kaltstart der Basisstation BTS anfangs von dem Betrieb der Kühleinrichtung VE abgesehen werden, um die Baugruppen schnell auf die gewünschte Betriebstemperatur erwärmen zu lassen und erst nach Erreichen dieser Betriebstemperatur eine weitere Regelung der Drehzahl der Kühleinrichtung VE zum Beibehalten der Betriebstemperatur durchzuführen.

Beim Kaltstart oder auch manuell bei einer Wartung der Basisstation BTS, kann beispielsweise durch die Änderung der Fügelstellung des Lüfterrades der Kühleinrichtungen VE die Luftströmung in dem Gehäuse umgekehrt werden, wodurch Kühlluft durch die Luftauslässe LA in das Gehäuse G einströmt und durch den Membranfilter MB herausgeführt wird. Dabei werden an der Oberfläche des Membranfilters MB abgesetzte Schmutzpartikel abgelöst und somit eine Reinigung des Membranfilters MB erreicht. Dieser Reinigungsvorgang kann beispielsweise auch durch eine permanente Messung des Luftdurchsatzes in Abhängigkeit von der Drehzahl der Kühlanordnung VE bei einem Unterschreiten eines fest vorgegebenen Wertes initiiert werden, wobei das gemessene Verhältnis den Grad der Verschmutzung des Membranfilters MB angibt.

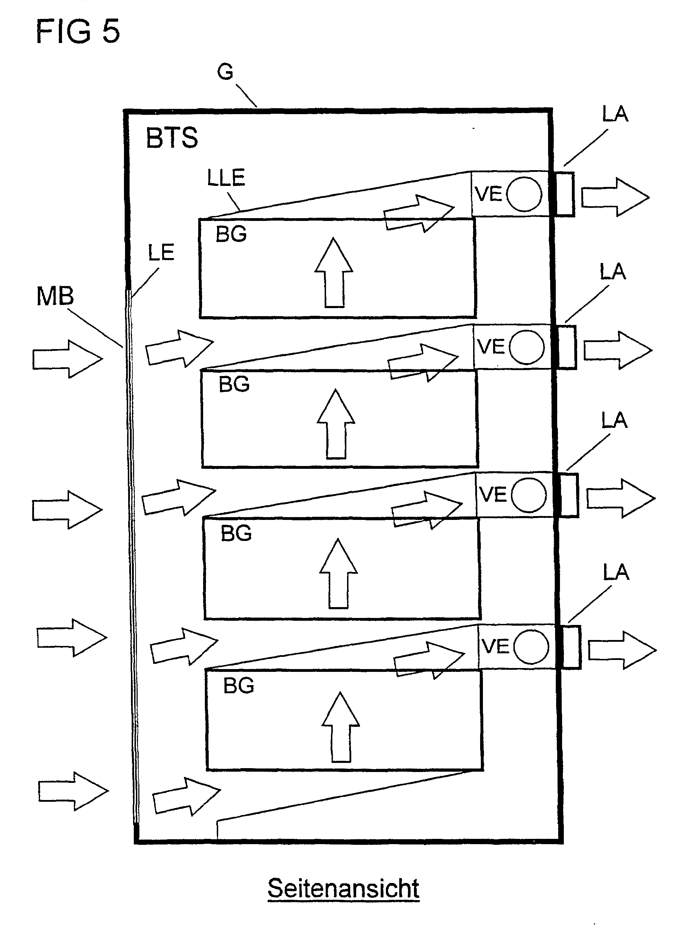

Die FIG 5 zeigt eine Basisstation BTS, bei der im Unterschied zu der Basisstation BTS in der FIG 4 jeweils oberhalb jeder elektrischen Baugruppe BG eine Kühleinrichtung VE mit jeweils einem Luftauslaß LA angeordnet sind. Durch die über jeweils einer Baugruppe BG angeordnete Luftleiteinrichtung LLE wird die durch das Durchströmen der Baugruppe BG erwärmte Kühlluft direkt zu den Kühleinrichtungen VE geführt. Diese Anordnung bietet den Vorteil, daß bei einem eventuellen Ausfall einer Kühleinrichtungen VE und einem dadurch notwendigen Abschalten der jeweiligen Baugruppe BG aufgrund der Gefahr der Überhitzung, alle weiteren Baugruppen BG weiterhin in Betrieb bleiben können. Somit kann in diesem Fall der Betrieb des Großteiles der Empfangspfade bzw. Sendepfade der Basisstation BTS durch die für jeden Pfad parallel aufgebauten Baugruppen BG sichergestellt werden. Für den Versorgungsbereich der Basisstation BTS kommt es dadurch nur zu einer unwesentlichen Einschränkung der Leistungskapazität gegenüber einem vollständigen Ausfall der Basisstation BTS bei einer Fehlfunktion der einzelnen Kühlanordnung VE gemäß den FIG 2, 3 und 4.

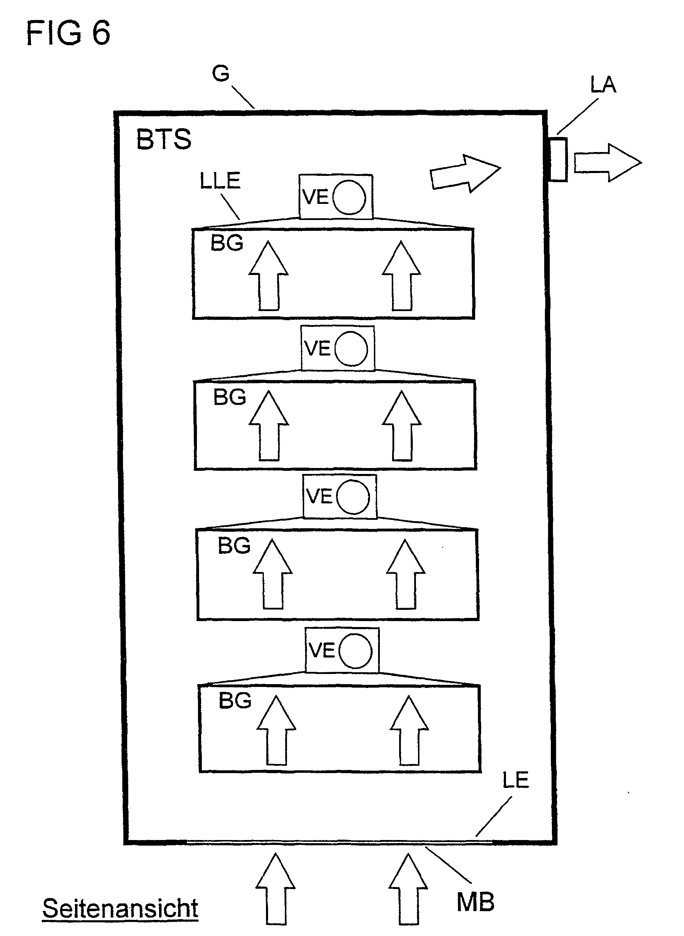

Die FIG 6 zeigt eine weitere Ausführungsform der erfindungsgemäßen Anordnung in einer Basisstation BTS. In dieser Ausführungsform ist der Lufteinlaß LE und entsprechend der Membranfilter MB an der Unterseite des Gehäuses G der Basisstation angeordnet, wodurch die einströmende Kühlluft direkt an den Unterseiten der Baugruppen BG angreift. Jeweils über den Baugruppen BG angeordnete Kühleinrichtungen VE bauen eine Luftströmung auf. Die durch das Durchströmen der jeweiligen Baugruppe BG erwärmte Kühlluft wird von einer trichterförmig ausgebildeten Luftleiteinrichtungen LLE direkt der Kühleinrichtung VE zugeführt. Die Kühlluft durchströmt somit sukzessiv in Form einer Serienkühlung alle Baugruppen und wird an einem oberhalb der obersten Baugruppen BG angeordneten Luftauslaß LA herausgeführt.

Im Übrigen können sowohl der Lufteinlaß LE als auch der jeweilige Luftauslaß LA an einer beliebigen Seite des Gehäuses G der Basisstation BTS angeordnet sein.

## Patentansprüche

1. Anordnung zum Kühlen von in einem Gehäuse (G) angeordneten elektrischen Baugruppen (BG), mit
- zumindest einem in jeweils einem Lufteinlaß (LE) des Gehäuses (G) angeordneten wasserabweisenden Membranfilter (MB) für eine Oberflächenfilterung von Schmutzpartikeln aus einströmender Kühlluft zum Kühlen der elektrischen Baugruppen (BG), und
- zumindest einer Kühleinrichtung (VE) zum Aufbauen einer Luftströmung in dem Gehäuse (G) und zum Herausführen der gefilterten, aufgrund eines Durchströmens der Baugruppen (BG) erwärmten, Kühlluft durch zumindest einen Luftauslaß (LA) aus dem Gehäuse (G).

2. Anordnung nach Anspruch 1, mit
einem jeweils unterhalb und/oder oberhalb der elektrischen Baugruppen (BG) angeordneten Luftleiteinrichtung (LLE) zum Leiten der gefilterten Kühlluft durch jeweils eine Baugruppe (BG).

3. Anordnung nach einem vorhergehenden Anspruch, mit einem jeweils unterhalb und/oder oberhalb der elektrischen Baugruppen (BG) angeordneten Luftleiteinrichtung (LLE) zum Abschirmen der Baugruppe (BG).

4. Anordnung nach einem vorhergehenden Anspruch, mit einem durch einen Motor angetriebenen Lüfterrad als Kühleinrichtung (VE).

5. Anordnung nach dem vorhergehenden Anspruch, mit einer Steuereinrichtung (ST) zum Steuern der Motordrehzahl der Kühleinrichtung (VE) in Abhängigkeit von der Temperatur im Inneren des Gehäuses (G) und/oder von der Temperatur der einströmenden Kühlluft.

6. Anordnung nach dem vorhergehenden Anspruch, bei der die Steuereinrichtung (ST) die Kühleinrichtung (VE) derart ansteuert, daß die Richtung der Luftströmung in dem Gehäuse (G) umgekehrt wird, so daß Kühlluft durch den Luftauslaß (LA) einströmt und durch den Membranfilter (MB) herausgeführt wird, wobei der Membranfilter (MB) durch die herausströmende Kühlluft von abgelagerten Schmutzpartikeln befreit wird.

7. Anordnung nach einem vorhergehenden Anspruch, bei der der Lufteinlaß (LE) im seitlichen und/oder unteren Bereich des Gehäuses (G) derart angeordnet ist, daß die einströmende Kühlluft an den Unterseiten der Baugruppen (BG) angreift.

8. Anordnung nach einem der vorhergehenden Ansprüche, bei der
der Luftauslaß (LA) zum Herausführen der gefilterten und erwärmten Kühlluft im oberen und/oder seitlichen Bereich des Gehäuses (G) angeordnet ist.

9. Basisstation (BTS) eines Mobilfunksystems oder eines Access-Network-Systems, mit
einer Anordnung zum Kühlen gemäß einem der Ansprüche 1 bis 8.

## Claims

1. Arrangement for cooling electrical subassemblies (BG) arranged in a housing (G), having
- at least one water-repellent membrane filter (MB), in each case arranged in an air inlet (LE) of the housing (G), for the surface filtration of dirt particles from cooling air flowing in for cooling the electrical subassemblies (BG), and
- at least one cooling device (VE) to build up an airflow in the housing (G) and to lead the filtered cooling air, heated up because of flowing through the subassemblies (BG), out of the housing (G) through at least one air outlet (LA).

2. Arrangement according to Claim 1, having an air guide device (LLE), arranged respectively underneath and/or above the electrical subassemblies (BG), to guide the filtered cooling air through one subassembly (BG) in each case.

3. Arrangement according to a preceding claim, having an air guide device (LLE), arranged respectively underneath and/or above the electrical subassemblies (BG), to shield the subassembly (BG).

4. Arrangement according to a preceding claim, having a motor-driven fan wheel as the cooling device (VE).

5. Arrangement according to the preceding claim, having a control device (ST) to control the motor speed of the cooling device (VE) as a function of the temperature in the interior of the housing (G) and/or of the temperature of the cooling air flowing in.

6. Arrangement according to the preceding claim, in which the control device (ST) controls the cooling device (VE) in such a way that the direction of the air flow in the housing (G) is reversed, so that cooling air flows in through the air outlet (LA) and is led out through the membrane filter (MB), the membrane filter (MB) being freed of deposited dirt particles by the cooling air flowing out.

7. Arrangement according to a preceding claim, in which the air inlet (LE) is arranged in the side and/or bottom area of the housing (G) in such a way that the cooling air flowing in acts on the undersides of the subassemblies (BG).

8. Arrangement according to one of the preceding claims, in which the air outlet (LA) for leading the filtered and heated cooling air out is arranged in the upper and/or side area of the housing (G).

9. Base station (BTS) of a mobile radio system or of an access network system, having an arrangement for cooling according to one of Claims 1 to 8.

## Revendications

1. Dispositif pour refroidir des composants (BG) électriques montés dans un boîtier (G), comportant
- au moins un filtre (MB) à membrane hydrophobe, monté dans une entrée (LE) d'air du boîtier (G), pour filtrer en surface des particules de saleté dans un air froid affluent servant à refroidir les composants (BG) électriques, et
- au moins un dispositif (VE) de refroidissement pour établir un courant d'air dans le boîtier (G) et pour amener à l'extérieur du boîtier (G), par au moins une sortie (LA) d'air, l'air froid filtré et réchauffé en raison d'un passage dans les composants (BG).

2. Dispositif suivant la revendication 1, comportant un dispositif (LLE) de guidage d'air monté respectivement au-dessous et/au-dessus des composants (BG) électriques pour guider l'air froid filtré dans chaque fois un composant (BG).

3. Dispositif suivant l'une des revendications précédentes, comportant un dispositif (LLE) de guidage d'air monté respectivement au-dessous et/au-dessus des composants (BG) électriques pour protéger les composants (BG).

4. Dispositif suivant l'une des revendications précédentes, comportant comme dispositif (VE) de refroidissement une roue de ventilateur entraînée par un moteur.

5. Dispositif suivant la revendication précédente, comportant un dispositif (ST) de commande pour commander la vitesse de rotation du moteur du dispositif (VE) de refroidissement en fonction de la température à l'intérieur du boîtier (G) et/ou de la température de l'air froid affluent.

6. Dispositif suivant la revendication précédente, dans lequel le dispositif (ST) de commande commande le dispositif (VE) de refroidissement de telle manière que la direction du courant d'air dans le boîtier (G) est inversée, si bien que de l'air froid afflue par la sortie (LA) d'air et est amené à l'extérieur par le filtre (MB) à membrane, le filtre (MB) à membrane étant dégagé de particules de saleté déposées par l'air froid s'écoulant à l'extérieur.

7. Dispositif suivant l'une des revendications précédentes, dans lequel l'entrée (LE) d'air est ménagée dans la zone latérale et/ou inférieure du boîtier (G) de telle manière que l'air froid affluent attaque les faces inférieures des composants (BG).

8. Dispositif suivant l'une des revendications précédentes, dans lequel la sortie (LA) d'air pour amener à l'extérieur l'air froid filtré et échauffé est ménagée dans la zone supérieure et/ou latérale du boîtier (G).

9. Station (BTS) de base d'un système de radiocommunications mobile ou d'un Access-Network-Systems comportant un dispositif de refroidissement suivant l'une des revendications 1 à 8.
